# EUROPÄISCHE PATENTANMELDUNG

(11) **EP 3 614 155 A1**
(43) Veröffentlichungstag der Anmeldung: **26.02.2020**
(21) Anmeldenummer: 18190178.6
(22) Anmeldetag: 22.08.2018
(51) Int. Cl.: G01R 31/08, G01R 31/12, G01N 21/95, H02G 1/02, G01J 1/42, G01N 21/88

(54) **VERFAHREN UND ANORDNUNG ZUM ERKENNEN VON KORONAENTLADUNGEN EINER ANLAGE MIT BETRIEBSMITTELN**

(71) Anmelder: Siemens Aktiengesellschaft, 80333 München (DE)
(72) Erfinder: Birchbauer, Josef Alois, 8054 Seiersberg (AT); Kähler, Olaf, 8052 Graz (AT)

(57) **Zusammenfassung**

Gegenstand der vorliegenden Erfindung ist ein Verfahren zum Erkennen von Koronaentladungen (5-15) einer Anlage (17) mit Betriebsmitteln (2,3), bei dem
- mittels eines Fahrzeugs (16) eine Sensoranordnung (18) an der Anlage (17) mit Betriebsmitteln (2,3) entlanggeführt wird, und
- für die Sensoranordnung (18) eine erste Kamera (20) zum Erfassen von UV-Strahlung mit einem Tageslichtfilter (21) zum Blockieren von Tageslicht verwendet wird, und
- mittels der Sensoranordnung (18) Bildaufnahmen der Anlage (17) aufgenommen werden,
dadurch gekennzeichnet, dass
- mittels einer Auswertungseinrichtung (22) die Bildaufnahmen der Kamera (20) mit einer dreidimensionalen Position gekennzeichnet werden, und dass
- mittels der Auswertungseinrichtung (22) mögliche Koronaentladungen (5-15) in jedem Einzelbild detektiert und anhand der jeweiligen dreidimensionalen Position in einen einzigen dreidimensionalen Raum übertragen werden, und dass
- mittels der Auswertungseinrichtung (22) eine räumliche Statistik über die Häufigkeit der möglichen Koronaentladungen erstellt wird, anhand derer tatsächliche Koronaentladungen (5-8,10,13-15) im Vergleich zu Rauschen als ortsfest und häufiger auftretend erkannt werden.

Ferner ist Gegenstand der vorliegenden Erfindung eine endsprechende Anordnung.

## Beschreibung

Die Erfindung betrifft ein Verfahren gemäß dem Oberbegriff des Anspruchs 1 sowie eine Anordnung gemäß dem Oberbegriff des Anspruchs 13.

Die bisher unveröffentlichte europäische Patentanmeldung 17161027.2 vom 15.03.2017 mit dem Titel "Verfahren und Anordnung für eine Zustandsüberwachung einer Anlage mit Betriebsmitteln" offenbart ein Verfahren für eine Zustandsüberwachung einer Anlage mit Betriebsmitteln, bei dem mittels eines ersten Fahrzeugs mit einer Überblickssensoranordnung zur optischen Erfassung der Anlage Überblicksdaten erfasst werden, und
mittels einer Auswerteeinrichtung in den Überblicksdaten die Betriebsmittel erkannt und unter Berücksichtigung der Position des ersten Fahrzeugs die Positionen der Betriebsmittel bestimmt werden, dadurch gekennzeichnet, dass
mittels eines zweiten Fahrzeugs mit einer Detailkamera, die auf die jeweiligen Positionen der Betriebsmittel ausgerichtet wird, Detailaufnahmen der Betriebsmittel erzeugt werden. Beispielsweise wird nur ein einziges Fluggerät wie z.B. eine Drohne oder ein Hubschrauber eingesetzt, um bei einem Überflug einer Freileitung mittels der Überblickskamera Masten und Isolatoren zu erkennen, die Position der Isolatoren zu bestimmen und anschließend mittels der Detailkamera hochaufgelöste Bilder der Isolatoren zu gewinnen. Hierdurch können schadhafte Isolatoren einfach und sicher erkannt werden.

Koronaentladungen an Elementen einer Freileitung oder anderen Hochspannungsinfrastrukturen sind ein bekanntes und zugleich unerwünschtes physikalisches Phänomen, das beispielsweise auf Wikipedia ausführlich beschrieben ist (permanenter Link: https://de.wikipedia.org/w/index.php?title=Koronaentladung&ol did=173331289). Durch eine Koronaentladung können in Verbindung mit dem Stickstoffgehalt der Umgebungsluft Säureprodukte entstehen, die Oberflachen von Hochspannungsarmaturen angreifen. Daneben haben Koronaentladungen auch noch andere unerwünschte Nebenwirkungen wie die Störung von Funkfrequenzbändern. Um Koronaentladungen zu verhindern, werden an Baugruppen wie z.B. Isolatoren Schutzarmaturen angebracht, sog. Koronaringe. Koronaringe sind beispielsweise auf Wikipedia beschrieben (permanenter Link: https://de.wikipedia.org/w/index.php?title=Koronaring&oldid=1 71645402).

Zumeist sind Koronaentladungen (v.a. unter Tageslichteinfluss) für das menschliche Auge nicht sichtbar. Es werden daher Kameras für den ultravioletten (UV) Frequenzbereich wie z.B. das Produkt DAYCOR der Firma OFIL (bekannt von der Website http://www.ofilsystems.com/products) eingesetzt. Solche Kameras sind mit einem Bildverstärker ausgestattet, der einzelne Lichtquanten sichtbar machen kann. Zudem ist ein Tageslichtsperrfilter verbaut, um den Einfluss des Tageslichtes zu minimieren. Bekannt im Stand der Technik sind diverse Vorverarbeitungsschritte, mit denen das Rohsignal in ein für einen menschlichen Betrachter einfacher zu erfassendes Bild umgewandelt wird. Dies geschieht zum Beispiel, indem ein Bild einer Anlage wie z.B. einer Oberleitung für Schienenfahrzeuge oder einer Freileitung im sichtbaren Spektrum des Lichts mit einem Bild im UV-Spektrum des Lichts überlagert wird. Eine Auswertung, ob angezeigte Entladungen eine relevante Korona darstellen, obliegt einem menschlichen Auswertungstechniker.

Aus Videoaufzeichnungen von Freileitungen mit einer eingangs beschriebenen Koronakamera ist oftmals ein gewisses Grundrauschen in den aufgezeichneten Signalen zu beobachten. Während in einem Einzelbild zahlreiche Entladungen aufgezeichnet worden sind, sind diese in zeitlich späteren Einzelbildern nicht mehr sichtbar. Aus dem Stand der Technik sind wenige Verfahren bekannt, um solche Bilder automatisch auszuwerten, insbesondere im Hinblick auf die ortsbezogene Detektion eines Koronaeffekts bei einem bewegten Aufnahmesystem.

Bekannt ist die Veröffentlichung "An Automatic Coronadischarge Detection System for Railways Based on Solar-blind Ultraviolet Detection" von Li et al., Current Optics and Photonics, Vol 1., No. 3, June 2017, pp. 196-202. In dem beschriebenen Ansatz wird - auf Schienenfahrzeuge zugeschnitten - die Linearbewegung der detektierten Koronapunkte direkt im Bildraum detektiert, wobei das Konzept einer sog. "Hough Transformation" (in 2D) zur Anwendung kommt. Dabei wird ausgenutzt, dass eine Koronaentladung in mehreren aufeinander folgenden Bildern als ein entlang einer geraden Linie bewegter heller Punkt erscheint, wenn das Schienenfahrzeug sich auf den geraden Bahngleisen daran vorbei bewegt. Das mathematische Verfahren der Hough Transformation ist beispielsweise auf Wikipedia erläutert (permanenter Link: https://de.wikipedia.org/w/index.php?title=Hough-Transformation&oldid=165672024). Ein weiteres System zur Erkennung von Koronaentladungen bei Schienenfahrzeugen ist das DayCor Rail System der Firma OFILSYSTEMS, bekannt von der Website http://www.ofilsystems.com/products.

An die Erfindung stellt sich die Aufgabe, ein Verfahren anzugeben, mit dem Koronaentladungen an Anlagen automatisch und zuverlässig festgestellt werden können.

Die Erfindung löst diese Aufgabe mit einem Verfahren gemäß Anspruch 1.

Eine Anlage kann beispielsweise eine elektrische Anlage wie eine Oberleitung oder eine Freileitung sein. Betriebsmittel einer elektrischen Anlage im Sinne der Erfindung können beispielsweise Isolatoren oder stromführende Kabel sein. Durch die erste Kamera wird UV-Licht aufgenommen. Das für Menschen sichtbare Licht wird üblicherweise mit Wellenlängen zwischen 380 nm bis 780nm angegeben, UV-Strahlung wird typischerweise mit 10 nm bis 380 nm angegeben (permanenter Link: https://de.wikipedia.org/w/index.php?title=Elektromagnetische s_Spektrum&oldid=178702023).
Bevorzugt kann durch die erste Kamera sog. schwache UV-Strahlung mit einer Wellenlänge zwischen 230 nm bis 380 nm detektiert werden. Noch mehr bevorzugt kann durch die zweite Kamera schwache UV-Strahlung im sog. solar-blinden Wellenlängenbereich, d.h. mit einer Wellenlänge zwischen 240 nm bis 280 nm, detektiert werden.

Der Tageslichtfilter der ersten Kamera bewirkt, dass das sichtbare Licht für diese Kamera ausgeblendet wird und Koronaentladungen z.B. als helle Lichtpunkte bzw. Lichtquellen vor ansonsten im Wesentlichen schwarzen Hintergrund erscheinen. Der Tageslichtfilter ist also ein Tageslichtsperrfilter, der alle anderen Tageslicht-Wellenlängen sperrt. Die nicht-gesperrten, hellen Lichtpunkte werden im Rahmen der Erfindung zunächst als mögliche Koronaentladungen erfasst. Bevorzugt soll ein Wellenlängenbereich von 240-280 nm mit der zweiten Kamera erfasst werden, da in diesem Bereich die UV-Strahlung der Sonne (Anteil des "Tageslichts") durch die Ozon-Schicht der Erder herausgefiltert wird. Damit ist alles (eine funktionierende Ozonschicht vorausgesetzt), was in diesem Wellenlängenbereich gemessen wird, irgendwie auf der Erde entstanden. Es kann daher vorausgesetzt werden, dass entsprechende Signale menschengemacht sind. Da aber nur sehr wenige Photonen in dem eingeschränkten Wellenlängenbereich empfangen werden, kann z.B. ein Bildverstärker zusammen mit dem Tageslichtfilter vorgesehen werden.

Als Auswertungseinrichtung kann beispielsweise eine herkömmliche Rechnereinrichtung mit entsprechendem Datenspeicher eingesetzt werden. Aus den Einzelbildern der beiden Kameras werden alle erfassten möglichen Koronaentladungen in den dreidimensionalen (3D) Raum projiziert. Anhand dieser Projektion kann die Statistik der erkannten hellen Punkte ermittelt werden, um tatsächliche Koronaentladungen von zufälligem Rauschen der Bildaufnahmen zu unterscheiden. Tatsächliche Koronaentladungen werden in einer zeitlichen Serie von einzelnen Bilder immer wieder am - im Bezug zum dreidimensionalen Raum - gleichen Ort auftauchen. Dies macht sie unterscheidbar von zufälligen Rauschsignalen, die ggf. nur kurze Zeit (bei einer geringen Anzahl von Einzelbildern oder sogar nur einem einzelnen Bild) auftauchen und ggf. an zufälligen Orten in einer Serie von Bildern auftauchen. In Abhängigkeit vom eingesetzten Kamerasystem für die Sensoranordnung kann durch Eichmessungen bzw. Tests mit künstlich erzeugten Koronaentladungen vorab ein geeigneter Schwellenwert für eine Häufigkeit von erkannten hellen Punkten festgelegt werden, so dass oberhalb des Schwellenwertes für die Häufigkeit von einer tatsächlichen Koronaentladung ausgegangen werden kann. Es können also volatile Entladungsphänomene von echten Entladungen automatisch unterschieden werden. Dabei wird insbesondere die Häufigkeit von falschen Alarmen bzw. falsch positiv erkannten Entladungen stark verringert, da wiederkehrende von spontanen Entladungseffekten separiert werden können.

Es ist ein entscheidender Vorteil des erfindungsgemäßen Verfahrens, dass bei der automatischen Erkennung der Koronaentladungen ein Bezug zu einer dreidimensionalen Geometrie hergestellt wird. Hierdurch kann beispielsweise bei einem Überflug mit einem Fluggerät eine genaue Position für jede Koronaentladung erkannt und abgespeichert werden. Dies erlaubt die genaue Auswertung und ggf. eine ortgenaue Wartung oder Reparatur von erkannten Schäden. Dieser Ansatz ermöglicht den Einsatz von Fluggeräten, da bei einer mobilen luftgetragenen Plattform wie z.B. einem Hubschrauber oder einer Dohne die aus dem Stand der Technik bekannte Lösung von Li et al. nicht einsetzbar ist, weil die Eigenbewegung des Fluggeräts i.d.R. keiner vorgegebenen oder vorab eingeschränkten (linearen) Form in den Einzelbildern folgt (im Gegensatz zu Schienenfahrzeugen).

Im Vergleich zu Auswertungen mit stationären Kameras erlaubt die Erfindung die Verwendung von frei bewegten Kameras. Hierdurch wird eine Lokalisation der Entladungen im dreidimensionalen Raum ermöglicht, während z.B. mit stationären Kameras und ohne weiteres Vorwissen über die aufgenommene Szene nur eine Einschränkung auf 3D Punkte entlang des Sehstrahles der jeweiligen Kamera möglich ist.

In einer bevorzugten Ausführungsform des erfindungsgemäßen Verfahrens wird für die Sensoreinrichtung zusätzlich eine Positionsbestimmungseinrichtung verwendet. Mit der Positionsbestimmungseinrichtung kann die dreidimensionale Position der jeweiligen möglichen Koronaentladung bzw. des hellen Punkts im UV-Bild ermittelt werden. Es können z.B. GPS-Signale ausgewertet werden. Z.B. wird jedem Einzelbild ein Zeitstempel und eine genaue Position des Fahrzeugs zugeordnet, woraus später im dreidimensionalen Raum anhand der Blickrichtung bzw. des Sehstrahls der Sensoranordnung eine genaue Position von möglichen Koronaentladungen berechnet werden kann. Zur Bestimmung der Blickrichtung kann beispielsweise ein Lagesensor verwendet werden. Bevorzugt kann ein Lagesensor eingesetzt werden, der die Ausrichtung anhand der sog. "Inertial Measurement Unity (IMU)" und/oder eines "Inertial Navigation System (INS)" bestimmt. Solche Lagesensoren sind beispielsweise von der Website des Unternehmens Vectornav bekannt (https://www.vectornav.com/support/library/imu-and-ins).

Im Rahmen der vorliegenden Erfindung bezeichnet die dreidimensionale Position einer möglichen oder tatsächlichen Koronaentladung also bereits ein Berechnungsergebnis, das sich aus der Position des Fahrzeugs und dem Blickwinkel der Kameras ergibt. Die Sensoranordnung gestattet es folglich, ggf. in Verbindung mit der Auswertungseinrichtung, die Position und Ausrichtung der UV-Kamera genau zu bestimmen.

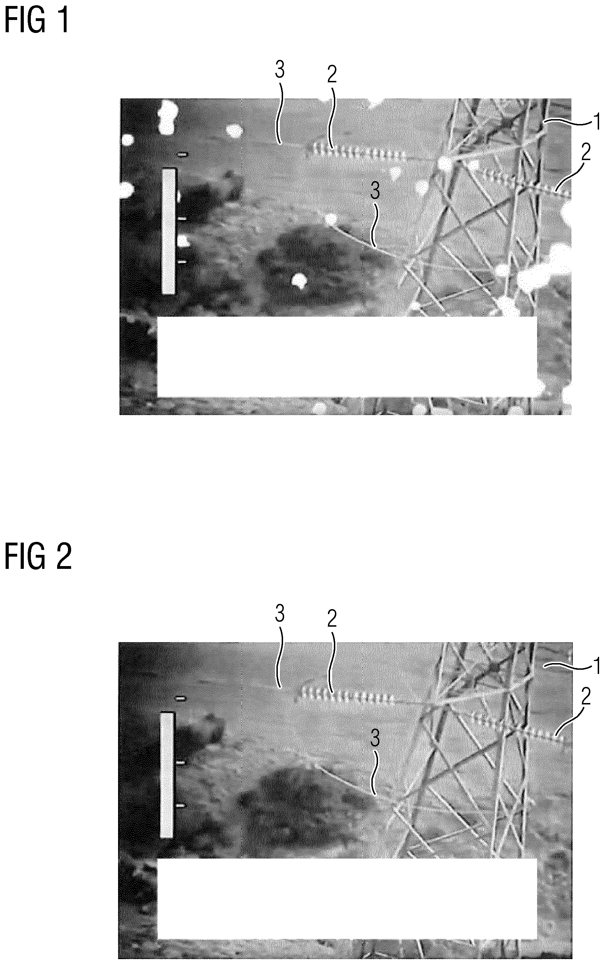

In einer bevorzugten Ausführungsform des erfindungsgemäßen Verfahrens wird für die Sensoranordnung zusätzlich eine zweite Kamera zum Erfassen von sichtbarem Licht verwendet, wobei mit der zweiten Kamera Bildaufnahmen der Anlage aufgenommen und mit einer dreidimensionalen Position gekennzeichnet werden. Dies hat den Vorteil, dass ein menschlicher Betrachter Bilder (wie z.B. die in Fig. 1 dargestellten Bilder) anschauen und ggf. eine manuelle Überprüfung oder einen Plausibilitätscheck in Bezug auf erkannte Koronaentladungen vornehmen kann. Die zweite Kamera nimmt gewöhnliche Tageslichtaufnahmen auf, zu denen die hellen Lichtpunkte in eine räumliche Relation gesetzt bzw. überlagert werden können.

In einer Weiterbildung der vorgenannten Ausführungsform kann anhand der Bildaufnahmen der zweiten Kamera mittels der Auswertungseinrichtung eine Photogrammetrie durchgeführt werden. Dabei können bei einer Bewegung der zweiten Kamera entlang der Anlage mehrere Bilder des gleichen Abschnitts der Anlage gewonnen werden. Alternativ oder zusätzlich können auch weitere Kameras für sichtbares Licht eingesetzt werden, um jederzeit mehrere Bilder der Anlage gewinnen zu können. Mit der Photogrammetrie kann aus den Bildaufnahmen der Anlage auf ihre räumliche Lage und/oder dreidimensionale Form geschlossen werden. Das Prinzip der Photogrammetrie ist beispielsweise von Wikipedia bekannt (permanenter Link: https://de.wikipedia.org/w/index.php?title=Photogrammetrie&ol did=179451745).

In einer bevorzugten Ausführungsform des erfindungsgemäßen Verfahrens erfolgt eine Überprüfung des Zustands und/oder eine Reparatur von Betriebsmitteln, an deren Positionen tatsächliche Koronaentladungen erkannt werden. Dies ist ein Vorteil, weil schnell und sicher ein optimaler Betriebszustand der Anlage wiederhergestellt werden kann, was weitere Schäden durch Koronaentladungen, weitere Funkstörungen oder sogar Ausfälle der Anlage verhindert.

In einer weiteren bevorzugten Ausführungsform des erfindungsgemäßen Verfahrens werden mittels eines Geoinformationssystems Informationen zu Betriebsmitteln an den Positionen von möglichen und/oder tatsächlichen Koronaentladungen bereitgestellt. Dies ist ein Vorteil, weil häufig Informationen zum Betriebszustand und ggf. bekannten Abnutzungen oder Wartungsanforderungen beim Betreiber der Anlage vorliegen. Diese Informationen können z.B. mit der Statistik verknüpft werden, um Koronaentladungen noch sicherer zu erkennen.

In einer weiteren bevorzugten Ausführungsform des erfindungsgemäßen Verfahrens wird die räumliche Statistik gebildet, indem jeder möglichen Koronaentladung im dreidimensionalen Raum eine Zahl von Einträgen in einem quantisierten dreidimensionalen Zählerstandsgitter zugewiesen wird, wobei anhand einer Blickrichtung der Sensoranordnung Sehstrahlen im dreidimensionalen Raum festgelegt werden, wobei im Falle einer Kreuzung mehrerer Sehstrahlen aus mehreren zeitlich versetzten Einzelbildern der Sensoranordnung an derselben dreidimensionalen Position in dem Zählerstandsgitter eine Häufung eingetragen wird. Dieses Konzept bedient sich beispielsweise eines sog. "Hough Space", also einer auf einen 3D-Raum bezogenen Erweiterung des eingangs beschriebenen Ansatzes von Hough. Diese Ausführungsform ist vorteilhaft, weil Sie zuverlässig ist. Dabei ist das quantisierte dreidimensionale Zählerstandsgitter beispielsweise als eine Unterteilung des dreidimensionalen Raumes in viele gleich große Würfel zu verstehen. Fällt die Position einer Koronaentladung in einen bestimmten Würfel, so wird der Zähler für diesen Würfel um 1 erhöht. Der Fachmann kann mittels einer Eichmessung eine geeignete Größe der Würfel finden, so dass die vermeintlichen Koronaentladungen ausreichend häufig in einem bestimmten Würfel auftauchen. Das quantisierte dreidimensionale Zählerstandsgitter wird folglich nach Art eines Histogramms genutzt.

In einer weiteren bevorzugten Ausführungsform des erfindungsgemäßen Verfahrens wird die räumliche Statistik gebildet, indem in den Bildaufnahmen jeweils mögliche Koronaentladungen detektiert werden und in zeitliche folgende Bildaufnahmen projiziert werden, wobei bei einer Übereinstimmung mit einer in den folgenden Bildaufnahmen erkannten möglichen Koronaentladung eine erhöhte Wahrscheinlichkeit für eine tatsächliche Koronaentladung angenommen wird. Liegen weitere mögliche Koronaentladungen vor, die nicht mit bereits bekannten hellen Lichtpunkten assoziiert werden können, so werden
entlang der entsprechenden Sehstrahlen weitere mögliche Koronaentladungen erfasst. Im Vergleich zur vorhergehenden Ausführungsform mit Zählerstandsgitter ist eine Reduktion des Speicherbedarfs in der Auswertungseinrichtung zu erwarten, was vorteilhaft ist.

In einer weiteren bevorzugten Ausführungsform des erfindungsgemäßen Verfahrens wird die räumliche Statistik unter Berücksichtigung eines vorbekannten dreidimensionalen Modells der Anlage erstellt, so dass in dem dreidimensionalen Modell ein Suchraum für Koronaentladungen auf die nahe Umgebung der Anlage eingeschränkt wird. Beispielsweise werden im dreidimensionalen Raum nur mögliche Koronaentladungen erfasst, die sich in der Nähe der Anlage wie z.B. einer Freileitung befinden. Die Koronaentladungen treten zwar nicht direkt auf physischen Objekten auf, die mit üblichen Verfahren vermessen werden (Leitungen, Isolatoren, etc.), sind jedoch in der Nähe (z.B. im Abstand einiger cm bis m) solcher Objekte zu erwarten. Die jeweiligen Rückprojektionen entlang der Sehstrahlen können somit mit korrespondierenden 3D-Objekten korreliert werden. Anstatt des gesamten Sehstrahles kann die weitere Verarbeitung auf einen Bereich um diese Objekte herum reduziert werden. Dies ist ein Vorteil, weil der Berechnungsaufwand für die Auswertungseinrichtung stark verringert wird. Die Auswertungseinrichtung kann in dieser Ausführungsform bei gegebener Rechengeschwindigkeit schneller ein Ergebnis finden oder mit deutlich verringerter Rechenleistung und damit Kosten eingesetzt werden.

In einer weiteren bevorzugten Ausführungsform des erfindungsgemäßen Verfahrens wird als Fahrzeug ein Fluggerät verwendet. Ein Fluggerät im Sinne der Erfindung ist jedes Objekt, dass sich nicht nur zweidimensional auf der Erdoberfläche auf z.B. einer Straße oder einem Bahngleis fortbewegt, sondern vielmehr auch in der Höhe oberhalb der Erdoberfläche. Der Einsatz eines Fluggeräts ist ein großer Vorteil, weil Anlagen schnell und zuverlässig durch einen Überflug inspiziert werden können, selbst wenn keine Straßen oder Ähnliches für eine Inspektion vom Boden aus vorhanden sind. Dies ist insbesondere für eine Freileitungsinspektion vorteilhaft.

In einer weiteren bevorzugten Ausführungsform des erfindungsgemäßen Verfahrens wird als Fluggerät ein Flugzeug, ein Helikopter oder eine Drohne verwendet.

In einer weiteren bevorzugten Ausführungsform des erfindungsgemäßen Verfahrens wird die Auswertungseinrichtung im Fahrzeug vorgesehen. Dies ist ein Vorteil, weil bereits während des Fluges eine Auswertung der Bilddaten der Sensoranordnung durchgeführt werden kann. Werden tatsächliche Koronaentladungen erkannt, so können die Koordinaten (z.B. GPS-Daten) entweder nach Ende der Inspektion der Anlage oder sogar sofort mittels einer Datenkommunikation per Funk zum Betreiber der Anlage übermittelt werden.

In einer weiteren bevorzugten Ausführungsform des erfindungsgemäßen Verfahrens wird die Auswertungseinrichtung als ein zentraler Server vorgesehen. Dies ist ein Vorteil, weil Gewicht und Platz für eine Auswertungseinrichtung an Bord des Fahrzeugs eingespart werden kann, was Kosten einspart. Insbesondere für Fluggeräte ist dies ein Vorteil. Die von den beiden Kameras erfassten Bilddaten können beispielsweise komprimiert und in einem Datenspeicher gesichert werden. Ein Auslesen des Datenspeichers erfolgt nach Ende der Inspektion. Alternativ können die Bilddaten sofort mittels einer Datenkommunikation per Funk zum zentralen Server übermittelt werden. Der zentrale Server kann beispielsweise als eine "Cloudapplication" ausgebildet sein.

In einer weiteren bevorzugten Ausführungsform des erfindungsgemäßen Verfahrens wird die dreidimensionale Position jeweils anhand von "Global Positioning System" (GPS) Daten ermittelt. Dies ist ein Vorteil, weil GPS lange erprobt, zuverlässig und genau ist.

An die Erfindung stellt sich ferner die Aufgabe, eine Anordnung anzugeben, mit der Koronaentladungen an Anlagen automatisch und zuverlässig festgestellt werden können.

Die Erfindung löst diese Aufgabe durch eine Anordnung gemäß Anspruch 13. Bevorzugte Ausführungsformen ergeben sich aus den Ansprüchen 13 bis 15.

In einer weiteren bevorzugten Ausführungsform der erfindungsgemäßen Anordnung ist die Auswertungseinrichtung im Fahrzeug vorgesehen.

In einer weiteren bevorzugten Ausführungsform der erfindungsgemäßen Anordnung ist die Auswertungseinrichtung als ein zentraler Server vorgesehen.

Es ergeben sich für die erfindungsgemäße Anordnung und ihre Ausführungsformen sinngemäß die gleichen Vorteile wie eingangs für das erfindungsgemäße Verfahren erläutert. Dem Fachmann ist dabei klar, dass die einzelnen für das erfindungsgemäße Verfahren beschriebenen Ausführungsformen, insbesondere die Ausgestaltungen der mittels der Auswertungseinrichtung vorgenommen Bildanalyseschritte, auch in der erfindungsgemäßen Anordnung verwirklicht und frei kombinierbar sind.

Zur besseren Erläuterung der Erfindung zeigen in schematischer Darstellung die
- Figur 1: eine erste Überlagerung eines Einzelbildes im sichtbaren Lichtspektrum mit einem Einzelbild im UV-Spektrum, und
- Figur 2: eine zweite, zeitlich nach der ersten Überlagerung gemäß Figur 1 angesiedelte Überlagerung eines Einzelbildes im sichtbaren Lichtspektrum mit einem Einzelbild im UV-Spektrum, und
- Figur 3: ein Ausführungsbeispiel der Erfindung.

Die Figuren 1 und 2 zeigen veröffentlichte, bekannte Bildaufnahmen. Ein Mast 1 mit Kabeln 3 und Betriebsmitteln wie z.B. Isolatoren 2 ist gezeigt. Es sind deutlich zahlreiche weiße bzw. helle Punkte zu erkennen, die mittels der UV-Kamera als UV-Quellen erfasst und dem sichtbaren Bild überlagert wurden. Diese hellen Punkte sind möglicherweise Koronaentladungen. In der Figur 2 ist derselbe Mast 1 etwas später dargestellt, wobei keine hellen Punkte mehr erkennbar sind.

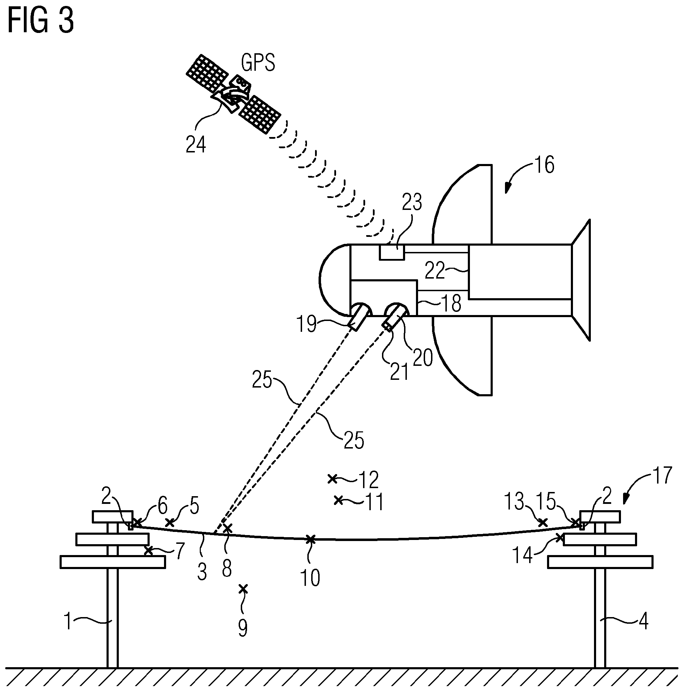

Die Figur 3 zeigt ein bevorzugtes Ausführungsbeispiel der Erfindung. Es sind eine Anlage 17, einer Freileitung mit einem ersten Mast 1 und einem zweiten Mast 4, Isolatoren 2 und Kabel 3 dargestellt. An den Masten 1,4 sind Kabel 3 vorhanden. Als Fahrzeug wird eine Drohne 16 eingesetzt, die eine Sensoranordnung 18 an der Anlage entlangführt. Die Sensoranordnung 18 weist eine zweite Kamera 19 zum Erfassen von sichtbarem Licht und eine erste Kamera 20 zum Erfassen von UV-Strahlung auf. Die erste Kamera 20 weist zusätzlich einen Tageslichtfilter 21 zum Blockieren von Tageslicht auf. Mit der Sensoranordnung 18 werden Bildaufnahmen der Anlage 17 aufgenommen und an Bord der Drohne 16 mit einer Auswertungseinrichtung 22 verarbeitet. Die Bildaufnahmen der beiden Kameras 19,20 werden mit einer dreidimensionalen Position gekennzeichnet, die mittels eines GPS-Satelliten und einer Positionsbestimmungseinrichtung 23 festgestellt wird. Mit der Positionsbestimmungseinrichtung 23 wird jedem Einzelbild ein Zeitstempel und eine genaue Position der Drohne 16 zugeordnet, woraus später im dreidimensionalen Raum anhand der Blickrichtung bzw. des Sehstrahls 25 der Sensoranordnung 18 die genaue Position von möglichen Koronaentladungen 5-15 berechnet werden kann.

Die Auswertungseinrichtung 22 erkennt mögliche Koronaentladungen 5-15 in jedem Einzelbild der zweiten Kamera 20 als helle Punkte. Anhand der jeweiligen dreidimensionalen Position des hellen Punktes wird dieser in einen einzigen dreidimensionalen Raum übertragen. Dies ermöglicht, die Informationen aus einer Zeitreihe von Bildern zu analysieren. Die Auswertungseinrichtung kann eine räumliche Statistik über die Häufigkeit der möglichen Koronaentladungen erstellen. Es können anhand der räumlichen Statistik tatsächliche Koronaentladungen 5-8, 10, 13-15 im Vergleich zu Rauschen als ortsfest und häufiger auftretend erkannt werden. Im gezeigten Beispiel sind die Koronaentladungen 5-8, 10, 13-15, die sich in unmittelbarer Nähe zur Anlage 17 befinden, auf diese Weise identifiziert worden. D.h., dass tatsächliche Koronaentladungen in einer zeitlichen Reihe von Bildern häufiger abgebildet werden als zufälliges Rauschen, dass immer wieder an anderen Orten auftritt und dabei nicht über mehrere Einzelbilder hinweg länger an einem Ort erkennbar ist.

Ein Geoinformationssystem (nicht dargestellt) kann Informationen zu Betriebsmitteln 2,3 and den Positionen von möglichen 5-15 und/oder tatsächlichen 5-8, 10, 13-15 Koronaentladungen bereitstellen.

## Patentansprüche

1. Verfahren zum Erkennen von Koronaentladungen (5-15) einer Anlage (17) mit Betriebsmitteln (2,3), bei dem
- mittels eines Fahrzeugs (16) eine Sensoranordnung (18) an der Anlage (17) mit Betriebsmitteln (2,3) entlanggeführt wird, und
- für die Sensoranordnung (18) eine erste Kamera (20) zum Erfassen von UV-Strahlung mit einem Tageslichtfilter (21) zum Blockieren von Tageslicht verwendet wird, und
- mittels der Sensoranordnung (18) Bildaufnahmen der Anlage (17) aufgenommen werden,
**dadurch gekennzeichnet, dass**
- mittels einer Auswertungseinrichtung (22) die Bildaufnahmen der Kamera (20) mit einer dreidimensionalen Position gekennzeichnet werden, und dass
- mittels der Auswertungseinrichtung (22) mögliche Koronaentladungen (5-15) in jedem Einzelbild detektiert und anhand der jeweiligen dreidimensionalen Position in einen einzigen dreidimensionalen Raum übertragen werden, und dass
- mittels der Auswertungseinrichtung (22) eine räumliche Statistik über die Häufigkeit der möglichen Koronaentladungen erstellt wird, anhand derer tatsächliche Koronaentladungen (5-8,10,13-15) im Vergleich zu Rauschen als ortsfest und häufiger auftretend erkannt werden.

2. Verfahren nach Anspruch 1, **dadurch gekennzeichnet, dass** für die Sensoranordnung (18) zusätzlich eine zweite Kamera (19) zum Erfassen von sichtbarem Licht verwendet wird, wobei mit der Kamera Bildaufnahmen der Anlage (17) aufgenommen und mit einer dreidimensionalen Position gekennzeichnet werden.

3. Verfahren nach Anspruch 1 oder 2, **dadurch gekennzeichnet, dass** eine Überprüfung des Zustands und/oder eine Reparatur von Betriebsmitteln (2,3) erfolgt, an deren Positionen tatsächliche Koronaentladungen (5-8, 10, 13-15) erkannt werden.

4. Verfahren nach einem der vorhergehenden Ansprüche, **dadurch gekennzeichnet, dass** mittels eines Geoinformationssystems Informationen zu Betriebsmitteln (2,3) an den Positionen von möglichen (5-15) und/oder tatsächlichen (5-8, 10, 13-15) Koronaentladungen bereitgestellt werden.

5. Verfahren nach einem der vorhergehenden Ansprüche, **dadurch gekennzeichnet, dass** die räumliche Statistik gebildet wird, indem jeder möglichen Koronaentladung (5-15) im dreidimensionalen Raum eine Zahl von Einträgen in einem quantisierten dreidimensionalen Zählerstandsgitter zugewiesen wird, wobei anhand einer Blickrichtung der Sensoranordnung (18) Sehstrahlen (25) im dreidimensionalen Raum festgelegt werden, wobei im Falle einer Kreuzung mehrerer Sehstrahlen aus mehreren zeitlich versetzten Einzelbildern der Sensoranordnung (18) an derselben dreidimensionalen Position in dem Zählerstandsgitter eine Häufung eingetragen wird.

6. Verfahren nach einem der vorhergehenden Ansprüche, **dadurch gekennzeichnet, dass** die räumliche Statistik gebildet wird, indem in den Bildaufnahmen jeweils mögliche Koronaentladungen (5-15) detektiert und in zeitlich folgende Bildaufnahmen projiziert werden, wobei bei einer Übereinstimmung mit einer in den folgenden Bildaufnahmen erkannten möglichen Koronaentladung eine erhöhte Wahrscheinlichkeit für eine tatsächliche Koronaentladung (5-8, 10, 13-15) angenommen wird.

7. Verfahren nach einem der vorhergehenden Ansprüche, **dadurch gekennzeichnet, dass** die räumliche Statistik unter Berücksichtigung eines vorbekannten dreidimensionalen Modells der Anlage (17) erstellt wird, so dass in dem dreidimensionalen Raum ein Suchraum für Koronaentladungen (5-15) auf die nahe Umgebung der Anlage (17) eingeschränkt wird.

8. Verfahren nach einem der vorhergehenden Ansprüche, **dadurch gekennzeichnet, dass** als Fahrzeug ein Fluggerät (16) verwendet wird.

9. Verfahren nach Anspruch 8, **dadurch gekennzeichnet, dass** als Fluggerät ein Flugzeug, ein Helikopter oder eine Drohne (16) verwendet wird.

10. Verfahren nach einem der vorhergehenden Ansprüche, **dadurch gekennzeichnet, dass** die Auswertungseinrichtung (22) im Fahrzeug vorgesehen wird.

11. Verfahren nach einem der Ansprüche 1 bis 9, **dadurch gekennzeichnet, dass** die Auswertungseinrichtung als ein zentraler Server vorgesehen wird.

12. Verfahren nach einem der vorhergehenden Ansprüche, **dadurch gekennzeichnet, dass** die dreidimensionale Position jeweils anhand von "Global Positioning System" (GPS) Daten ermittelt wird.

13. Anordnung zum Erkennen von Koronaentladungen einer Anlage mit Betriebsmitteln, aufweisend
ein Fahrzeug (16), das ausgebildet ist, eine Sensoranordnung (18) an einer Anlage (17) mit Betriebsmitteln (2,3) entlang zu führen, wobei
die Sensoranordnung (18) eine erste Kamera (20) zum Erfassen von UV-Strahlung aufweist, und wobei die erste Kamera (20) einen Tageslichtfilter (21) zum Blockieren von Tageslicht aufweist, und
wobei die Sensoranordnung (18) ausgebildet ist, Bildaufnahmen der Anlage (17) aufzunehmen, und wobei
das Fahrzeug (16) eine Positionsbestimmungseinrichtung (23) aufweist,
**dadurch gekennzeichnet, dass**
eine Auswertungseinrichtung (22) ausgebildet ist,
die Bildaufnahmen der Kamera (20) mit einer dreidimensionalen Position zu kennzeichnen, und
mögliche Koronaentladungen (5-15) in jedem Einzelbild zu detektieren und anhand der jeweiligen dreidimensionalen Position in einen einzigen dreidimensionalen Raum zu übertragen, und
eine räumliche Statistik über die Häufigkeit der möglichen Koronaentladungen (5-15) zu erstellen, anhand derer tatsächliche Koronaentladungen (5-8, 10, 13-15) im Vergleich zu Rauschen als ortsfest und häufiger auftretend erkennbar sind.

14. Anordnung nach Anspruch 13, **dadurch gekennzeichnet, dass** die Sensoranordnung (18) eine zweite Kamera (19) zum Erfassen zum Erfassen von sichtbarem Licht aufweist, wobei mittels der Positionsbestimmungseinrichtung (23) mit der Kamera aufgenommene Bildaufnahmen der Anlage (17) mit einer dreidimensionalen Position kennzeichenbar sind.

15. Anordnung nach einem der Ansprüche 13 bis 14, **dadurch gekennzeichnet, dass** das Fahrzeug ein Flugzeug, ein Helikopter oder eine Drohne (16) ist.
